# EUROPÄISCHE PATENTSCHRIFT

(11) **EP 1 927 862 B1**
(45) Veröffentlichungstag und Bekanntmachung des Hinweises auf die Patenterteilung: **04.11.2020**
(21) Anmeldenummer: 07017903.1
(22) Anmeldetag: 12.09.2007
(51) Int. Cl.: G01R 13/02

(54) **Vorrichtung zur Auswahl einer Farbstufe und einer Helligkeitsstufe für Bildpunkte eines Displays**
Device for selecting a colour shade and a brightness degree for pixels on a screen
Dispositif de sélection d'une teinte des couleurs et d'un échelon de brillance pour des pixels d'un écran

(30) Priorität: 28.11.2006 DE 102006056153
(43) Veröffentlichungstag der Anmeldung: 04.06.2008
(73) Patentinhaber: Rohde & Schwarz GmbH & Co. KG, 81671 München (DE)
(72) Erfinder: Schmidt, Kurt, Dr., 85567 Grafing (DE)
(74) Vertreter: Körfer, Thomas

(56) Entgegenhaltungen:
- EP-A- 0 822 416
- EP-A- 1 340 987
- EP-A2- 0 962 779
- US-A- 5 153 711
- US-A1- 2003 231 187
- US-A1- 2004 008 160
- FLEISCHHEUER H-P: "DIE DRITTE SIGNAL-DIMENSION ERSCHLIESSEN" ELEKTRONIK, WEKA FACHZEITSCHRIFTENVERLAG, POING, DE, Bd. 47, Nr. 13, 23. Juni 1998 (1998-06-23), Seiten 56-60, XP000868723 ISSN: 0013-5658
- "DSO DISPLAYS: ALMOST AS GOOD AS ANALOG", TEST AND MEASUREMENT WORLD, REED BUSINESS INFORMATION, HIGHLANDS RANCH, CO, US, vol. 20, no. 2, 1 February 2000 (2000-02-01), page 41/42,44,46,48,50,52, XP000975946, ISSN: 0744-1657

## Beschreibung

Die Erfindung betrifft ein Verfahren und eine Vorrichtung zur Auswahl einer Farbstufe und einer Helligkeitsstufe für Bildpunkte eines Displays (Darstellungsoberfläche).

Zur Darstellung einer dreidimensionalen Signalinformation auf dem Display einer Anzeige-Einrichtung eines Messgerätes bzw. -systems wird anstelle einer perspektivischen dreidimensionalen Darstellung eine konventionelle zweidimensionale Display-Darstellung mit einer Farb- oder Helligkeitsstufe kombiniert. Hierbei wird anstelle einer monochromen Ausleuchtung des jeweiligen Bildpunkts des Displays in zwei Helligkeitsstufen - ausgeleuchteter oder nicht ausgeleuchtete Bildpunkt - bei einer zweidimensionalen Darstellung der jeweilige Bildpunkt des Displays entweder polychrom in verschiedenen Farbstufen bei einer Helligkeitsstufe oder monochrom in einer Farbstufe bei verschiedenen Helligkeitsstufen ausgeleuchtet.

Für die Ausleuchtung eines Bildpunkts auf einem Display ist neben der Farb- oder Helligkeitsstufe als eine die darzustellende Signalinformation repräsentierende Beleuchtungsinformation als weitere Beleuchtungsinformation die Ausleuchtungsdauer des jeweiligen Bildpunktes relevant. Aufgrund der zyklischen Aktualisierung der einzelnen Bildpunkte des Displays mit neuen Signalinformationen in einem bestimmten Zeitraster sind die einzelnen Bildpunkte nicht nur für jeweils einen Aktualisierungszeitpunkt, sondern für jeweils ein Zeitintervall des Zeitrasters nach dem Aktualisierungszeitpunkt auszuleuchten. Die im jeweiligen Aktualisierungszeitpunkt des Zeitrasters für den jeweiligen Bildpunkt des Displays vorliegende Beleuchtungsinformation ist folglich über ein Zeitintervall des Zeitraster zu verlängern (so genannter Persistence-Effekt der Ausleuchtung des Bildpunkts).

Zum Persistance-Effekt sei beispielsweise auf die EP 0 398 042 B1 verwiesen.

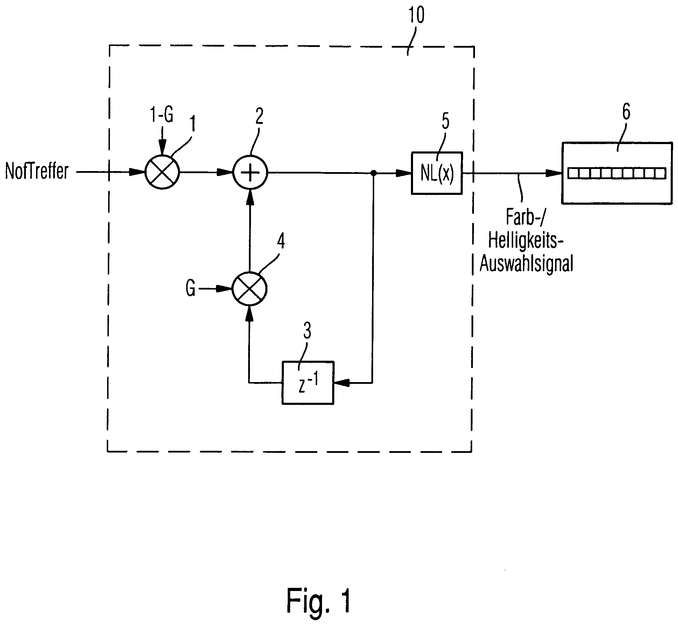

Eine bislang übliche Vorrichtung 10, die für einen Bildpunkt des Displays das Nachleuchten und die Auswahl einer Farb- oder Helligkeitsstufe verwirklicht, ist in Fig. 1 dargestellt. Die Farb- oder Helligkeitsstufe des Bildpunktes wird hierbei in Abhängigkeit der Häufigkeit von Signalpegeln eines zeit- oder frequenzabhängigen Mess-Signals ausgewählt, welche in einem Beobachtungsintervall in einem zum Bildpunkt gehörigen Signalpegelbereich und zu einem zum Bildpunkt gehörigen Wert des verwendeten Zeit- oder Frequenzrasters erfasst werden.

Das Eingangsignal mit dem im jeweiligen Bildpunkt des Displays darzustellenden Häufigkeitswert wird in einem rekursiven digitalen Filter erster Ordnung in der Größenordnung eines Gedächtnisfaktors G zeitlich verlängert. Das rekursive digitale Filter besteht hierzu aus einem ersten Multiplizierglied 1, das das Eingangsignal mit dem Faktor 1-G gewichtet, und einen nachfolgenden Addierglied 2, das das mit dem Faktor 1-G gewichtete Eingangsignal zu einem in einem Rückführzweig des rekursiven digitalen Filters rückgeführten Ausgangssignals des rekursiven digitalen Filters addiert. Im Rückführzweig wird das am Ausgang des Addiergliedes 2 anliegende Ausgangssignal des rekursiven digitalen Filters in einem Verzögerungsglied 3 um eine Abtastzeit verzögert und in einem dem Verzögerungsglied 3 nachfolgenden zweiten Multiplizierglied 4 mit dem Gedächtnisfaktor G gewichtet.

Da die Anzahl der auf dem Display verfügbaren Farb- oder Helligkeitsstufen im allgemeinen geringer als der Werteumfang der ermittelten und vom Eingangssignal repräsentierten Häufigkeitswerte ist, erfolgt in einer dem rekursiven digitalen Filter nachgeschalteten Abbildungs-Einheit 5 eine Umsetzung des zum ermittelten Häufigkeitswert korrespondierenden Signalpegels des zeitlich verlängerten Eingangsignals in ein Farb- oder Helligkeitsauswahlsignal mit einem Signalwert, der der zum Häufigkeitswert korrespondierenden Farb- oder Helligkeitsstufe entspricht. Mit dem derart erzeugten Farb- oder Helligkeitsauswahlsignal wird eine Speicherzelle in einer Speicherzeile eines nachfolgenden Speichers 6 adressiert, in der die zum Signalpegel des Farb- oder Helligkeitsauswahlsignals gehörige Farbstufe oder Helligkeitsstufe abgelegt ist.

Die Vorrichtung gemäß Fig. 1 weist den Nachteil auf, dass die zeitliche Verlängerung des Eingangsignals im rekursiven digitalen Filter eine Absenkung des Signalwerts des zeitlich verlängerten Eingangssignals bedingt und damit nicht die zur Häufigkeit gehörige Farb- oder Helligkeitsstufe des jeweiligen Bildpunkts über ein Beobachtungsintervall gehalten, sondern mehrere Farb- oder Helligkeitsstufen entsprechend dem absinkenden Signalwert des zeitlich verlängerten Eingangsignals zeitlich nacheinander selektiert werden. Auf diese Weise geht dem Anwender die zum ermittelten Häufigkeitswert gehörige Farb- oder Helligkeitsstufe unerwünscht sehr schnell verloren.

Das Dokument EP 1 340 987 A2 zeigt ein digitales Oszilloskop mit einer Anzeige.

Das Dokument US 2003/0231187 A1 zeigt ein Anzeigegerät und eine Ansteuerarchitektur zur Verbesserung der Leistung.

Das Dokument US 2004/0008160 A1 zeigt eine Architektur zur Verbesserung der Informationsdarstellung auf Messgeräten bei langen Akquisitionszeiten oder beschränkten Speicherbandbreiten.

Das Dokument US 5,153,711 zeigt ein Messgerät mit einer regenbogenartigen Nachleucht-Eigenschaft des Displays.

Das Dokument Fleischheuer H-P: "Die dritte Signal-Dimension erschließen", Elektronik, WK Fachzeitschriftenverlag, Poing, DE, BD. 47, Nr. 13, 13. Juni 1998 zeigt die Simulation einer Persistenz-Funktion auf einem Digitalmessgerät.

Das Dokument EP 0 822 416 A2 zeigt ein Verfahren und eine Vorrichtung zur Verbesserung der zeitvarianten Darstellung von Signalen auf digitalen Displays.

Das Dokument EP 0 962 779 A2 zeigt ein Messgerät mit einer digitalen Anzeige mit einer simulierten Persistenz.

Das Dokument "DSO Displays: Almost as Good as Analog", Test and Measurement World, Read Business Information, Highlands Ranch, CO, US, BD. 20, Nr. 2, 1. Februar 2000 zeigt eine emulierte Persistenz analoger Anzeigen auf digitalen Anzeigen.

Aufgabe der Erfindung ist es deshalb, eine Vorrichtung und ein Verfahren zur Auswahl einer geeigneten Beleuchtung für einen Bildpunkt in einem Display zu schaffen, die bzw. das einerseits eine zum ermittelten Häufigkeitswert korrespondierende Beleuchtungsinformation - beispielsweise Farb- oder Helligkeitsstufe der Bildpunkt-Beleuchtung - ermöglicht und andererseits ein Nachleuchten des Bildpunktes über einen gewissen Zeitpunkt hinaus gewährleistet.

Die Aufgabe wird durch eine erfindungsgemäße Vorrichtung zur Auswahl einer Farbstufe und einer Helligkeitsstufe für Bildpunkte eines Displays mit den Merkmalen des Anspruchs 1 gelöst. Die Unteransprüche enthalten vorteilhafte Weiterbildungen der Erfindung.

Die eindimensionale Beleuchtungsinformation der Bildpunkte des Displays - Farbstufen oder Helligkeitsstufen - nach dem Stand der Technik wird erfindungsgemäß in eine zweidimensionale Beleuchtungsinformation bestehend aus jeweils einer Farbstufe und einer Helligkeitsstufe überführt. Zur Selektion der zweidimensionalen Beleuchtungsinformation wird in Abhängigkeit des ermittelten Häufigkeitswerts ein die Farbstufe selektierendes Farbauswahlsignal und ein die Helligkeitsstufe selektierendes Helligkeitsauswahlsignal erzeugt.

Zur Erzeugung des Farbauswahlsignals und des Helligkeitsauswahlsignals wird für den Fall einer eindimensionalen Beleuchtungsinformation jeweils eine serielle Anordnung aus einer Verzögerungs-Einheit bestehend aus einem rekursiven digitalen Filter und einer Abbildungs-Einheit mit einer nichtlinear gestuften Kennlinie verwendet.

Über das Farbstufenauswahlsignal und das Helligkeitsauswahlsignal wird die zur Farbstufe und Helligkeitsstufe des Farbauswahlsignals und des Helligkeitsauswahlsignals gehörige Speicherzelle eines Speichers adressiert, in der die aus jeweils einer unterschiedlichen Kombination aus einer Farbstufe und einer Helligkeitsstufe zusammengesetzte zweidimensionale Beleuchtungsinformation gespeichert ist.

In der ersten seriellen Anordnung zur Erzeugung des Farbauswahlsignals ist die erste Verzögerungs-Einheit der ersten Abbildungs-Einheit nachgeschaltet. Die erste Abbildungs-Einheit erzeugt ein Farbauswahlsignal mit einem eine Farbstufe repräsentierenden Signalwert, der dem ermittelten Häufigkeitswert entspricht. Die erste Verzögerungs-Einheit stellt ein nichtlineares rekursives digitales Filter zur Fixierung der zu selektierenden Farbstufe des Farbauswahlsignals über mindestens ein Beobachtungsintervall dar.

Auf diese Weise bleibt die zum ermittelten Häufigkeitswert gehörige Farbstufe zumindest bis zu einem der folgenden Beobachtungsintervalle, in dem ein neuer, von "0" verschiedener Häufigkeitswert ermittelt wird, im Gegensatz zum Stand der Technik erfindungsgemäß fixiert.

In der zweiten seriellen Anordnung zur Erzeugung eines Helligkeitsauswahlsignals ist die zweite Verzögerungs-Einheit der ersten Abbildungs-Einheit vorgeschaltet. Die zweite Verzögerungs-Einheit stellt ein nichtlineares rekursives digitales Filter zur verzögerten Reduzierung der zu selektierenden Helligkeitsstufe des Helligkeitsauswahlsignals über mehrere Abtastzeitpunkte dar. Hierzu wird bei einem von "0" verschiedenen, den ermittelten Häufigkeitswert repräsentierenden Signalwert des Eingangssignal ein der höchsten Helligkeitsstufe entsprechender Wert eines Helligkeitssignal vom Eingang an den Ausgang des nichtlinearen rekursiven digitalen Filters geschaltet. . Sobald der vom Eingangsignal repräsentierte Häufigkeitswert auf den Wert "0" zurückgesetzt wird, wird das um eine Abtastzeit verzögerte und mit einem Gedächtnisfaktor G gewichtete Helligkeitssignal am Ausgang des nichtlinearen rekursiven digitalen Filters wiederum an den Ausgang des nichtlinearen rekursiven digitalen Filters zurückgeführt. Auf diese Weise wird das Helligkeitssignal am Ausgang des nichtlinearen rekursiven digitalen Filters sukzessive von Abtastzeitpunkt zu Abtastzeitpunkt in seinem Signalpegel reduziert.

An den Ausgang des nichtlinearen rekursiven digitalen Filters wird erst dann ein Helligkeitssignal mit einer dem höchsten Helligkeitsstufe entsprechenden Signalwert geschaltet, wenn in einem der nächsten Beobachtungsintervalle der Signalwert des Eingangsignals einen neuen Häufigkeitswert repräsentiert. Der Wert des Helligkeitssignals am Ausgang der zweiten Verzögerungs-Einheit wird von der zweiten Abbildungs-Einheit in ein Helligkeitsauswahlsignal umgesetzt, dessen Signalwert der zum Wert des Helligkeitssignals korrespondierenden Helligkeitsstufe entspricht.

Auf diese Weise bleibt bis zu einem der folgenden Beobachtungsintervalle, in dem ein neuer, von "0" verschiedener Häufigkeitswert erfasst wird, eine von "0" verschiedene Helligkeit des Bildpunkts auf dem Display erhalten.

In einer weiteren Ausführungsform der erfindungsgemäßen Vorrichtung zur Auswahl einer Farbstufe und einer Helligkeitsstufe für Bildpunkte eines Displays wird für den Fall, dass in einem Beobachtungsintervall kein neuer von "0" verschiedener Häufigkeitswert ermittelt wird, anstelle eines Häufigkeitswertes "0" eine über alle in bisherigen Beobachtungsintervallen ermittelten Häufigkeitswerte berechnete statistische Kenngröße im Bildpunkt des Displays dargestellt. Bei der statistischen Kenngröße kann es sich beispielsweise um den Maximalwert, den Minimalwert oder den Mittelwert aller bisher ermittelten Häufigkeitswerte handeln.

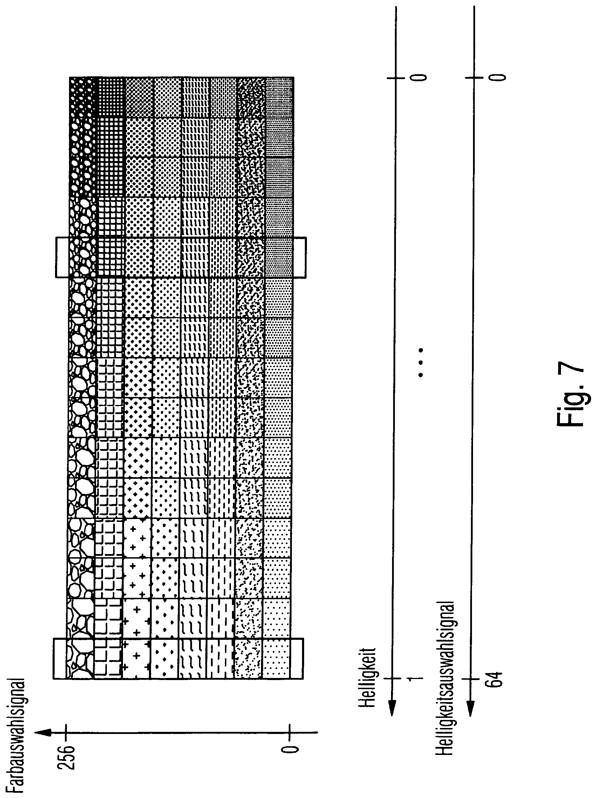

Die Farbstufe, in der der Bildpunkt zur Darstellung der statistischen Kenngröße ausgeleuchtet wird, entspricht den Wert der berechneten statistischen Kenngröße. Der die Farbstufe kennzeichnende Signalwert des zusätzlichen Farbauswahlsignals wird aus dem Signalwert des die statistischen Kenngröße repräsentierenden Eingangsignals statNofTreffer über die nichtlineare gestufte Kennlinie einer dritten Abbildungseinheit ermittelt. Die Helligkeitsstufe, in der der Bildpunkt zur Darstellung der statistischen Kenngröße ausgeleuchtet wird, ist eine frei wählbare, gegenüber den zu den aktualisierten Häufigkeitswerten gehörigen Helligkeiten zusätzliche dunklere Helligkeit, beispielsweise die in Fig. 7 rechtsseitig eingerahmte durch eine Graustufe repräsentierte Helligkeitsstufe. Diese zusätzliche dunklere Helligkeit wird über die nichtlineare gestufte Kennlinie einer vierten Abbildungseinheit in einen Signalwert eines zusätzlichen Helligkeitsauswahlsignals umgesetzt, der der zur zusätzlichen dunkleren Helligkeit korrespondierenden Helligkeitsstufe entspricht.

Über einen dritten Schalter wird die Ansteuerung des Speichers vom Farb- bzw. Helligkeitsauswahlsignal zum zusätzlichen Farb- bzw. zusätzlichen Helligkeitsauswahlsignal umgeschaltet. Die Umschaltung erfolgt, wenn die in der zweiten seriellen Anordnung ermittelte Helligkeit unter die frei wählbare zusätzliche Helligkeit sinkt und gleichzeitig ein von "0" verschiedener Wert der ermittelten statistischen Kenngröße vorliegt. Auf diese Weise ist gewährleistet, dass die sich verdunkelnde Helligkeitsstufe beim Nachleuchten des Bildpunkts im Falle eines Nichtvorliegens eines neuen Häufigkeitswertes in die dunkelste Helligkeitsstufe bei der Darstellung der ermittelten statistischen Kenngröße im Bildpunkt stetig übergeht und nicht unter diese Helligkeitsstufe sinkt.

Die beiden Ausführungsformen der erfindungsgemäßen Vorrichtung zur Auswahl einer Farbstufe und einer Helligkeitsstufe für Bildpunkte eines Displays werden im folgenden anhand der Zeichnung im Detail erläutert. Die Figuren der Zeichnung zeigen:
- Fig. 1: ein Blockschaltbild einer Vorrichtung zur Auswahl einer Farb- oder Helligkeitsstufe für Bildpunkte eines bislang üblichen Displays,
- Fig. 2: ein Blockschaltbild einer ersten Ausführungsform der erfindungsgemäßen Vorrichtung zur Auswahl einer Farbstufe und einer Helligkeitsstufe für Bildpunkte eines Displays,
- Fig. 3: ein Flussdiagramm eines Verfahrens das mit Hilfe der ersten Ausführungsform der erfindungsgemäßen Vorrichtung zur Auswahl einer Farbstufe und einer Helligkeitsstufe für Bildpunkte eines Displays durchgeführt werden kann,
- Fig. 4: eine nichtlineare Kennlinie einer Abbildungseinheit zur Erzeugung des Farbauswahlsignals in der erfindungsgemäßen Vorrichtung zur Auswahl einer Farbstufe und einer Helligkeitsstufe für Bildpunkte eines Displays,
- Fig. 5: eine nichtlineare Kennlinie einer Abbildungseinheit zur Erzeugung des Helligkeitsauswahlsignals in der erfindungsgemäßen Vorrichtung zur Auswahl einer Farbstufe und einer Helligkeitsstufe für Bildpunkte eines Displays,
- Fig. 6: die Zeitverläufe des Eingangs- und des Ausgangssignals einer Verzögerungseinheit zur Erzeugung eines Helligkeitssignals in der erfindungsgemäßen Vorrichtung der Auswahl einer Farbstufe und einer Helligkeitsstufe für Bildpunkte eines Displays,
- Fig. 7: eine zweidimensionale Darstellung der Speicherbelegung des Speichers der erfindungsgemäßen Vorrichtung mit aus jeweils einer Farb- und einer Helligkeitsstufe zusammengesetzten Beleuchtungsinformation,
- Fig. 8: ein Blockschaltbild einer zweiten Ausführungsform der erfindungsgemäßen Vorrichtung zur Auswahl einer Farbstufe und einer Helligkeitsstufe für Bildpunkte eines Displays und
- Fig. 9: ein Flussdiagramm eines Verfahrens das mit Hilfe der zweiten Ausführungsform der erfindungsgemäßei Vorrichtung zur Auswahl einer Farbstufe und einer Helligkeitsstufe für Bildpunkte eines Displays durchgeführt werden kann.

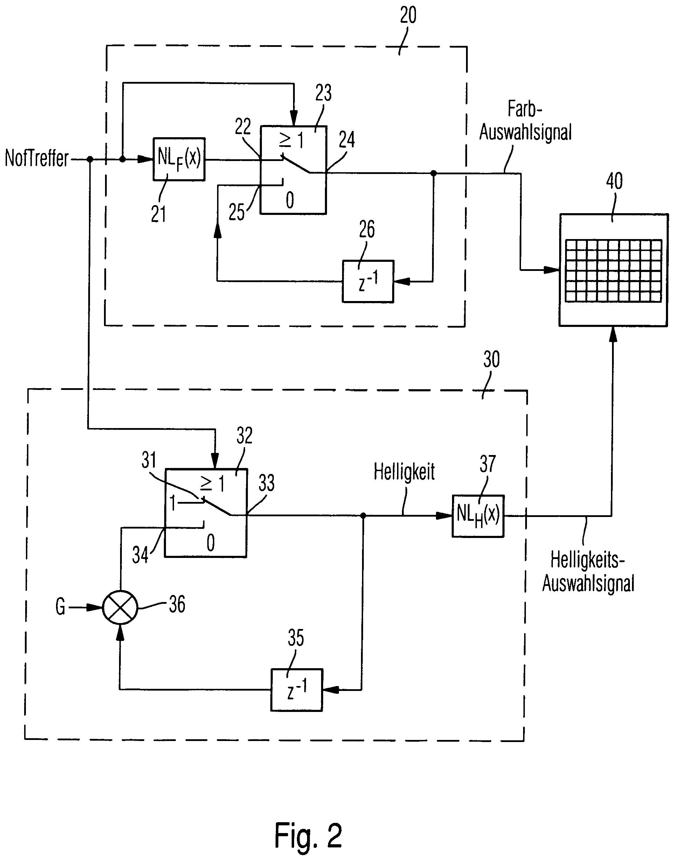

Im folgenden wird die erste Ausführungsform der erfindungsgemäßen Vorrichtung zur Auswahl einer Farbstufe und einer Helligkeitsstufe für Bildpunkte eines Displays anhand der Figuren 2, 4, 5, 6 und 7 beschrieben.

Das in der Fig. 2 schematisch gezeigte Ausführungsbeispiel der erfindungsgemäßen Vorrichtung besteht aus einer ersten seriellen Anordnung 20 zur Erzeugung eines Farbauswahlsignals, einer zweiten seriellen Anordnung 30 zur Erzeugung eines Helligkeitsauswahlsignals und einem Speicher 40, der vom Farbauswahlsignal und vom Helligkeitsauswahlsignal angesteuert wird und in seinen einzelnen Speicherzellen jeweils eine Beleuchtungsinformation für einen Bildpunkt eines Displays einer Anzeige-Einrichtung enthält.

Der ersten seriellen Anordnung 20 wird ein Eingangssignal NofTreffer zugeführt, dessen Signalwert der in einem Beobachtungsintervall in einem zum Bildpunkt gehörigen Signalpegelbereich und zu einem zum Bildpunkt gehörigen Wert des verwendeten Zeit- oder Frequenzrasters ermittelten Häufigkeit von erfassten Signalpegeln eines Mess-Signals entspricht.

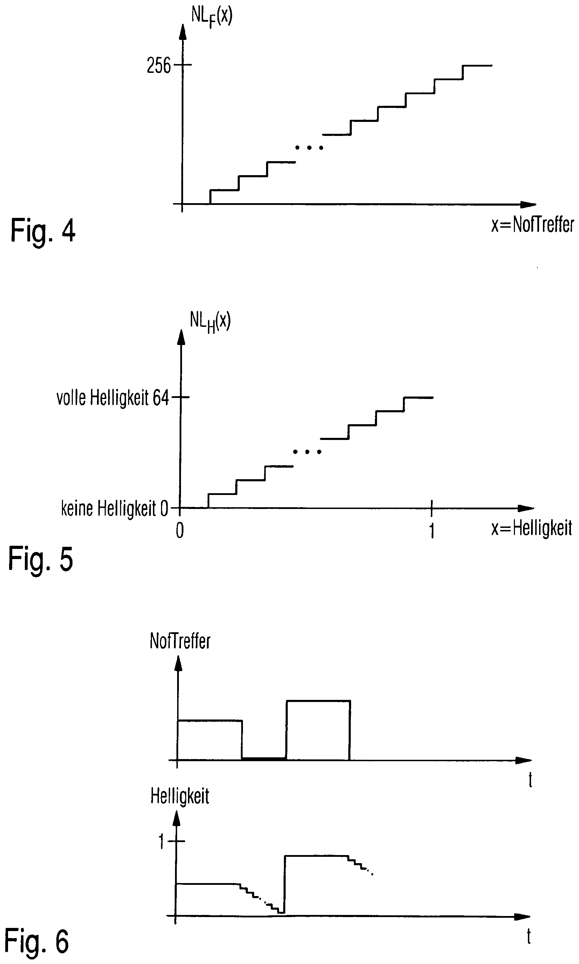

Dieses Eingangsignal wird an den Eingang einer ersten Abbildungseinheit 21 geführt, die mit ihrer nichtlinear gestuften Kennlinie gemäß Fig. 4 ein Ausgangssignal erzeugt, dessen Signalwert der zur ermittelten Häufigkeitswert des Eingangssignals korrespondierenden Farbstufe entspricht. Für die Auswahl der Farbstufe wird gemäß Fig. 4 ein digitales Ausgangssignal mit einer Bitbreite von beispielsweise 8 Bit benutzt, womit insgesamt 256 verschiedene Farbstufen selektierbar sind.

Das Ausgangssignal der ersten Abbildungseinheit 21 wird an einen ersten Eingang 22 eines ersten Schalters 23 gelegt. Der erste Schalter 23 schaltet das an seinem Eingang 22 anliegende Ausgangssignal der ersten Abbildungseinheit 21 mit der zum ermittelten Häufigkeitswert korrespondierenden Farbstufe an seinen Ausgang 24 durch und bildet dort das Farbauswahlsignal mit der zum ermittelten Häufigkeitswert korrespondierenden Farbstufe, solange das Eingangsignal NofTreffer der ersten seriellen Anordnung 20 einen ermittelte Häufigkeitswert von mindestens "1" repräsentiert.

Sobald der ermittelte Häufigkeitswert des Eingangsignals NofTreffer nach Ablauf eines Beobachtungsintervalls auf den Wert "0" zurückgesetzt wird, wird das Signal am zweiten Eingang 25 des ersten Schalters 23 an den Ausgang 24 des ersten Schalters 23 durchgeschaltet. Das Signal am zweiten Eingang 25 des ersten Schalters 23 ergibt sich aus dem Signal am Ausgang 24 des ersten Schalters 23 durch zeitliche Verzögerung um eine Abtastzeit in einer ersten Verzögerungseinheit 26. Auf diese Weise wird am Ausgang 24 des ersten Schalters 23 das Ausgangssignal der ersten Abbildungseinheit 21 mit der zum zuletzt ermittelten Häufigkeitswert des Eingangsignals NofTreffer korrespondierenden Farbstufe gehalten.

Wird in einem der nächsten Beobachtungsintervalle ein neuer von "0" verschiedener Häufigkeitswert ermittelt, so wird das Ausgangssignal der ersten Abbildungseinheit 21 mit der zum neuen Häufigkeitswert korrespondierenden Farbstufe von ersten Eingang 22 an den Ausgang 24 des ersten Schalters 23 durchgeschaltet.

Die erste serielle Anordnung 20 bewirkt also eine Fixierung der zum ermittelten Häufigkeitswert korrespondierenden Farbstufe im Farbauswahlsignal am Ausgang 24 des ersten Schalters 23 über mehrere Beobachtungsintervalle, bis in einem der folgenden Beobachtungsintervalle ein neuer, von "0" verschiedener Häufigkeitswert ermittelt wird.

Das Eingangsignal NofTreffer mit dem jeweils ermittelten Häufigkeitswert wird zusätzlich einer zweiten seriellen Anordnung 30 zugeführt. Weist das Eingangsignal NofTreffer eine von "0" verschiedenen Häufigkeitswert auf, so wird das Eingangsignal am ersten Eingang 31 des zweiten Schalters 32 mit seinem Signalwert "1" an den Ausgang 33 des zweiten Schalters 32 durchgeschaltet und bildet dort ein Helligkeitssignal mit der zum Signalwert "1" korrespondierenden höchsten Helligkeit.

Sobald der ermittelte Häufigkeitswert des Eingangsignals NofTreffer nach Ablauf eines Beobachtungsintervalls auf den Wert "0" zurückgesetzt wird, wird das Signal am zweiten Eingang 34 des zweiten Schalters 32 an den Ausgang 33 durchgeschaltet. Das Signal am zweiten Eingang 34 des zweiten Schalters 32 ergibt sich aus dem Helligkeitssignal am Ausgang 33 des zweiten Schalters 32 durch zeitliche Verzögerung um eine Abtastzeit in einer zweiten Verzögerungseinheit 35 und durch anschließende Gewichtung mit einem Gedächtnisfaktor G in einem Multiplizierglied 36.

Da der Gedächtnisfaktor G einen Wert zwischen "0" und "1" aufweist, reduziert sich der Signalwert des Helligkeitssignals am Ausgang 33 des zweiten Schalters 32, wie aus den Zeitdiagrammen der Fig. 6 hervorgeht, von Abtastzeitpunkt zu Abtastzeitpunkt, solange der Häufigkeitswert im Eingangssignal NofTreffer zurückgesetzt ist und in einer der folgenden Beobachtungsintervalle noch kein neuer, von "0" verschiedenen Häufigkeitswert vorliegt. Sobald in einer der folgenden Beobachtungsintervalle ein neuer, von "0" verschiedener Häufigkeitswert im Eingangsignal NofTreffer auftritt, wird gemäß der Zeitdiagramme in Fig. 6 das Signal am ersten Eingang 31 des zweiten Schalters 32 mit dem Signalwert "1" an den Ausgang 33 des zweiten Schalters 32 durchgeschaltet.

Das Helligkeitssignal am Ausgang 33 des zweiten Schalters 32 wird an den Eingang einer zweiten Abbildungseinheit 37 geführt, die eine nichtlinear gestufte Kennlinie gemäß Fig. 5 aufweist und den Helligkeitswert des Helligkeitssignals mit einem Wertebereich zwischen "0" und "1" in ein Helligkeitsauswahlsignal umsetzt, dessen Signalwert einer zum Helligkeitswert des Helligkeitssignals korrespondierenden Helligkeitsstufe entspricht. Für die Auswahl der Helligkeitsstufe wird gemäß Fig. 5 ein digitales Ausgangssignal mit einer Bitbreite von beispielsweise 6 Bit benutzt, womit insgesamt 64 verschiedene Helligkeitsstufen selektierbar sind.

Die zweite serielle Anordnung 30 bewirkt also ein vom Gedächtnisfaktor G abhängiges zeitliches Abklingverhalten des Helligkeitsauswahlsignals nach dem Zurücksetzen des Häufigkeitswerts im Eingangsignal NofTreffer und damit ein Nachleuchten des jeweiligen Bildpunkts im Display der Anzeige-Einrichtung bis zu einem der folgenden Beobachtungsintervalle, in dem ein neuer von "0" verschiedener Häufigkeitswert erfasst wird.

Über den Signalwert des Farbauswahlsignals, der der zu selektierenden Farbstufe entspricht, und über den Signalwert des Helligkeitsauswahlsignals, der der zu selektierenden Helligkeitsstufe entspricht, wird die zum beleuchtenden Bildpunkt des Displays gehörige Speicherzelle des Speichers 40 adressiert. In der adressierten Speicherzelle des Speichers 40 ist die aus der selektierten Farbstufe und der selektierten Helligkeitsstufe zusammengesetzte Beleuchtungsinformation für den Bildpunkt des Displays abgespeichert. Die in den einzelnen Speicherzellen des Speichers 40 für einen Bildpunkt des Displays abgelegten Beleuchtungsinformationen sind gemäß Fig. 7 bevorzugt in einer zweidimensionalen, orthogonalen Matrix angeordnet, wobei in einer ersten Dimension - in Fig. 7 beispielsweise in der Abszissen-Richtung - die als verschiedene Graustufen dargestellten Helligkeitsstufen und in einer zweiten Dimension - in Fig. 7 beispielsweise in der Ordinaten-Richtung - die als verschiedene Muster dargestellten Farbstufen variiert werden.

Die in Fig. 2 dargestellte erfindungsgemäße Vorrichtung aus einer ersten seriellen Anordnung 20, einer zweiten seriellen Anordnung 30 und einem Speicher 40 dient einzig der Beleuchtung eines einzigen Bildpunkts eines Displays einer Anzeige-Einrichtung. Die Anordnung entsprechend Fig. 2 ist für die übrigen Bildpunkte des Displays jeweils entsprechend zu vervielfältigen. Die zweidimensionale orthogonale Anordnung der einzelnen Farbstufen und Helligkeitsstufen in den einzelnen Speicherzellen des Speichers 40 gemäß Fig. 7 kann auch durch eine andere von der Erfindung abgedeckte Anordnung ersetzt werden, wozu das Farbauswahlsignal und das Helligkeitsauswahlsignal zur Selektion der mit einer aus einer Farbstufe und einer Helligkeitsstufe zusammengesetzten Beleuchtungsinformation belegten Speicherzelle jeweils über eine Umsetz-Einheit geführt werden muß.

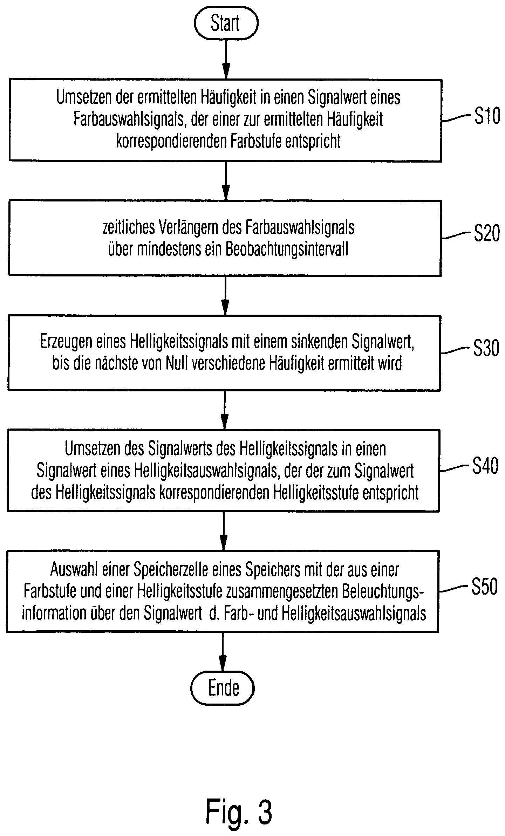

Im folgenden wird anhand des Flussdiagramms der Fig. 3 ein mit der ersten Ausführungsform der erfindungsgemäßen Vorrichtung durchführbares Verfahren zur Auswahl einer Farbstufe und einer Helligkeitsstufe für Bildpunkte eines Displays beschrieben.

Im erste Verfahrenschritt S10 wird der Signalwert eines Eingangsignals NofTreffer der erfindungsgemäßen Vorrichtung, der dem Häufigkeitswert der in einem Beobachtungsintervall in einem bestimmten Signalpegelbereich und zu einem bestimmten Wert des verwendeten Zeit- oder Frequenzrasters jeweils erfassten Signalpegel eines Mess-Signals entspricht und in einem Bildpunkt eines Displays einer Anzeige-Einrichtung als Farbstufe dargestellt wird, durch eine erste Abbildungseinheit 21 in einen Signalwert eines Farbauswahlsignals umgesetzt, der der zum ermittelten Häufigkeitswert korrespondierenden Farbstufe entspricht. Die Umsetzung des Signalwerts des Eingangsignals NofTreffer, dessen Wertebereich der Anzahl von Messzyklen NofFrames eines Beobachtungsintervalls entspricht, in den korrespondierenden Signalwert des Farbauswahlsignals, dessen Wertebereich im allgemeinen kleiner als der Wertebereich des Signalwerts des Eingangsignals NofTreffer ist und typischerweise bei einer Bitbreite von 8 Bit des digitalen Farbauswahlsignals 256 verschiedene Signalwerte aufweist, erfolgt durch eine nichtlineare gestufte Kennlinie der ersten Abbildungseinheit 21.

Im nächsten Verfahrenschritt S20 wird der im jeweiligen Beobachtungsintervall generierte Signalwert des Farbauswahlsignals durch eine erste Verzögerungseinheit, welche als nichtlineares rekursives digitales Filter erster Ordnung realisiert ist, zeitlich fixiert, bis in einem der folgenden Beobachtungsintervalle ein neuer, von "0" verschiedener Häufigkeitswert ermittelt wird und damit ein neuer Signalwert des Farbauswahlsignals vorliegt. Auf diese Weise wird die zum fixierten Signalwert des Farbauswahlsignals gehörige Farbstufe der für den Bildpunkt vorgesehenen Beleuchtungsinformation bis zur Selektion der zum neu ermittelten Häufigkeitswert gehörigen neuen Farbstufe gehalten.

Im darauf folgenden Verfahrensschritt S30 wird ein bei Vorliegen eines von "0" verschiedenen Häufigkeitswertes auf den Signalwert "1" festgesetztes Helligkeitssignal, das der höchsten Helligkeit entspricht, mit Zurücksetzen des Häufigkeitswertes auf den Wert "0" in seinem Signalwert solange reduziert, bis in einem der nächsten Beobachtungsintervalle ein von "0" verschiedener Häufigkeitswert ermittelt wird. Auf diese Weise wird ein Nachleuchten des Bildpunkts mit einem stetig sinkenden Helligkeitswert verwirklicht, bis der Bildpunkt bei Vorliegen eines neuen Häufigkeitswertes wieder mit der höchsten Helligkeit ausgeleuchtet wird.

Im nächsten Verfahrensschritt S40 wird der im vorherigen Verfahrenschritt S30 ermittelte Signalwert des Helligkeitssignals über eine zweite Abbildungseinheit 37 mit einer nichtlinearen gestuften Kennlinie in einen Signalwert des Helligkeitsauswahlsignal umgesetzt, der einer zum Signalwert des Helligkeitssignals korrespondierenden Helligkeitsstufe entspricht.

Im abschließenden Verfahrenschritt S50 wird über das Farbauswahlsignal und das Helligkeitsauswahlsignal diejenige Speicherzelle eines Speichers 40 adressiert, in der die aus einer Farbstufe und einer Helligkeitsstufe zusammengesetzte Beleuchtungsinformation abgelegt ist, die zum Signalwert des Farbauswahlsignals und zum Signalwert des Helligkeitsauswahlsignals korrespondiert. Mit dieser Beleuchtungsinformation wird der Bildpunkt des Displays mit der jeweiligen Farbstufe und der jeweiligen Helligkeitsstufe angesteuert.

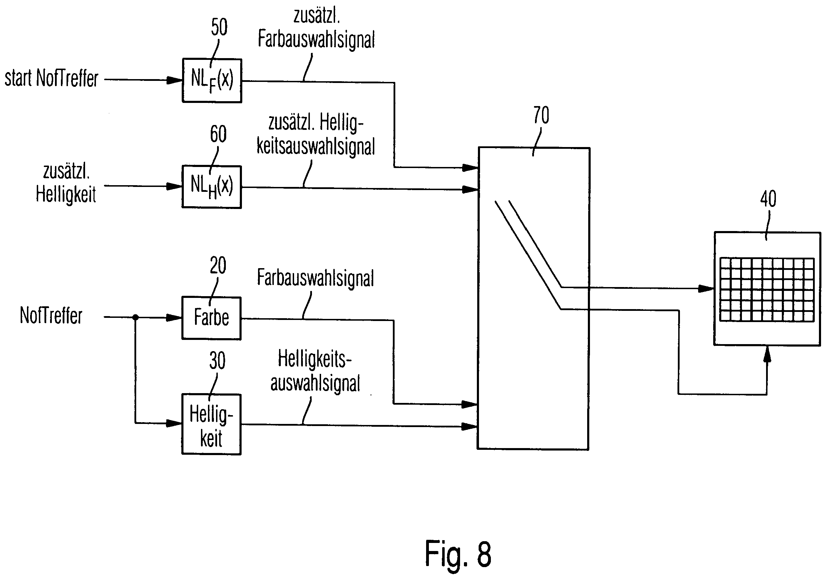

Die zweite Ausführungsform der erfindungsgemäße Vorrichtung zur Auswahl einer Farbstufe und einer Helligkeitsstufe für Bildpunkte eines Displays in Fig. 8 besteht aus einer ersten seriellen Anordnung 20 und einer zweiten seriellen Anordnung 30 zur Erzeugung eines Farbauswahlsignals und eines Helligkeitsauswahlsignals in Abhängigkeit eines den ermittelten Häufigkeitswert repräsentierenden Signalwerts des Eingangsignals NofTreffer entsprechend der ersten Ausführungsform der erfindungsgemäßen Vorrichtung in Fig. 2.

Das zusätzliche Farbauswahlsignal, dessen Signalwert der zum Wert der ermittelten statistischen Kenngröße des Eingangsignals statNofTreffer korrespondierenden Farbstufe entspricht, wird aus dem Eingangsignal statNofTreffer über eine dritte Abbildungseinheit 50 mit einer nichtlinearen gestufte Kennlinie gewonnen.

Das zusätzliche Helligkeitsauswahlsignal, dessen Signalwert der zum frei wählbaren zusätzlichen Helligkeitswert korrespondierenden Helligkeitsstufe entspricht, wird über eine vierte Abbildungseinheit 60 mit einer nichtlinearen gestuften Kennlinie aus dem Eingangsignal mit dem frei wählbaren zusätzlichen Helligkeitswert am Eingang der vierten Abbildungseinheit 60 gewonnen.

Ein dritter Schalter 70 schaltet anstelle des Farbauswahlsignals und des Helligkeitsauswahlsignals das zusätzliche Farbauswahlsignal und das zusätzliche Helligkeitsauswahlsignal an den Speicher 40 durch, wenn die in der zweiten seriellen Anordnung 20 ermittelte Helligkeit kleiner oder gleich dem frei wählbaren zusätzlichen Helligkeitswert am Eingang der vierten Abbildungseinheit 60 ist und gleichzeitig ein von "0" verschiedener Wert der ermittelten statistischen Kenngröße statNoftReffer vorliegt.

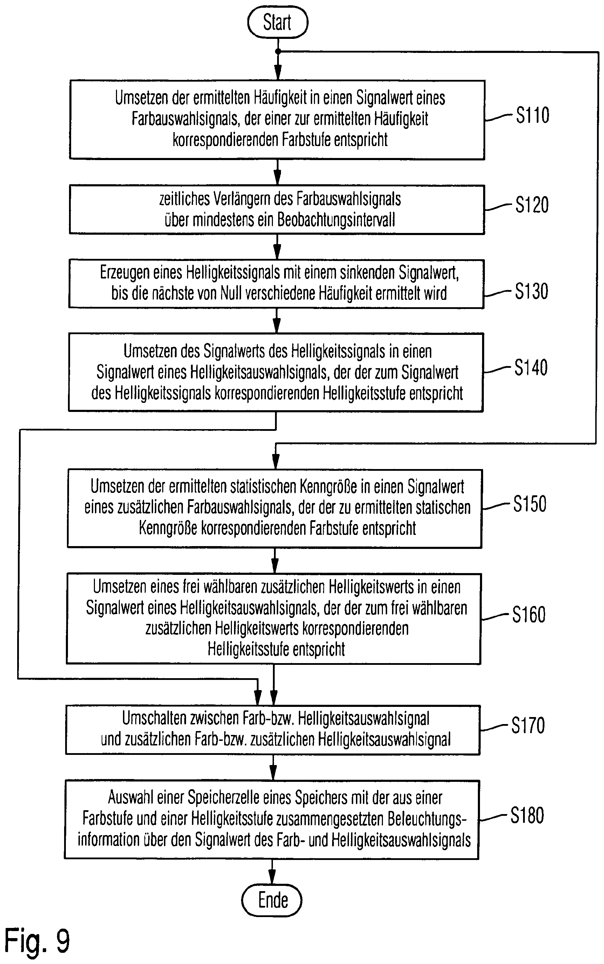

Ein mit der zweiten Ausführungsform der erfindungsgemäßen Vorrichtung durchführbares zweites Verfahren zur Auswahl einer Farbstufe und einer Helligkeitsstufe für Bildpunkte eines Displays in Fig. 9 enthält zu den Verfahrensschritten S10, S20, S30 und S40 des erster Verfahrens identische Verfahrenschritte S110, S120, S130 und S140.

Im darauf folgenden Verfahrenschritt S150 wird parallel zu den Verfahrensschritten S110, S120, S130 und S140 in jedem Beobachtungsintervall die aus den in bisherigen Beobachtungsintervallen jeweils ermittelten Häufigkeitswerten berechnete statistische Kenngröße - beispielsweise der Mittelwert, der Maximalwert oder der Minimalwert -, die vom Signalwert der Eingangsgröße statNTreffer repräsentiert wird, über eine dritte Abbildungseinheit 50 mit einer nichtlinearen gestuften Kennlinie in den Signalwert eines zusätzlichen Farbauswahlsignals umgesetzt, der derjenigen Farbstufe entspricht, die zur ermittelten Wert der statistischen Kenngröße korrespondiert.

Im nächsten Verfahrensschritt S160 wird der frei wählbare zusätzliche Helligkeitswert zur Darstellung der statistischen Kenngröße im Bildpunkt des Displays, der gegenüber den einzelnen Helligkeitswerten zur Darstellung der ermittelten Häufigkeitswerte im Bildpunkt des Displays einen dunkleren Helligkeitswert darstellt, über eine vierte Abbildungseinheit 60 mit einer nichtlinearen gestuften Kennlinie in einen Signalwert eines zusätzlichen Helligkeitsauswahlsignals umgesetzt, der derjenigen Helligkeitsstufe entspricht, die zur frei wählbaren Helligkeit korrespondiert.

Im darauf folgenden Verfahrenschritt S170 wird entweder das Farb- bzw. Helligkeitsauswahlsignal oder das zusätzliche Farb- bzw. zusätzlichen Helligkeitsauswahlsignal an einen Speicher 40 über einen dritten Schalter 70 weitergeschaltet. Die Weiterschaltung vom Farb- bzw. Helligkeitsauswahlsignal zum zusätzlichen Farb- bzw. zusätzlichen Helligkeitsauswahlsignal erfolgt, wenn die für einen ermittelten Häufigkeitswert abklingende Helligkeit des Helligkeitssignals in der zweiten seriellen Anordnung 20 der erfindungsgemäßen Vorrichtung unter den frei wählbaren zusätzlichen Helligkeitswert sinkt und gleichzeitig ein neuer, von "0" verschiedener Wert der statistischen Kenngröße vorliegt. Die Weiterschaltung vom zusätzlichen Farb- bzw. zusätzlichen Helligkeitsauswahlsignal zum Farb- bzw. Helligkeitsauswahlsignal erfolgt wiederum, wenn für einen neu ermittelten Häufigkeitswert die höchste Helligkeit mit einem Signalwert von "1" des Helligkeitssignals in der zweiten seriellen Anordnung 20 der erfindungsgemäßen Vorrichtung ermittelt wird, die somit höher als der frei wählbare zusätzliche Helligkeitswert ist.

Im abschließenden Verfahrenschritt S180 wird in Analogie zum abschließenden Verfahrenschritt S50 des ersten Verfahrens in Fig. 3 über das weitergeschaltete Farb- bzw. Helligkeitsauswahlsignal oder das weitergeschaltete zusätzliche Farb- bzw. zusätzliche Helligkeitsauswahlsignal diejenige Speicherzelle eines Speichers 40 selektiert, in der ein aus einer Farbstufe und einer Helligkeitsstufe zusammengesetzte Beleuchtungsinformation zur Ausleuchtung eines Bildpunkts eines Displays abgelegt ist, die dem Signalwert des Farb- und Helligkeitsauswahlsignals entspricht. Die im Speicher 40 selektierte Beleuchtungsinformation aus einer Farbstufe und einer Helligkeitsstufe wird zur Ansteuerung des Bildpunkts eines Displays herangezogen.

Die Erfindung ist nicht auf die dargestellten Ausführungsformen beschränkt. Von der Erfindung sind insbesondere auch analoge Realisierungen der Eingangssignale NofTreffer bzw. statNofTreffer nit abgedeckt.

## Patentansprüche

1. Vorrichtung zur Auswahl einer aus einer Farbstufe und einer Helligkeitsstufe zusammengesetzten Beleuchtungsinformation für jeden Bildpunkt auf einem Display einer Anzeige-Einrichtung in Abhängigkeit einer innerhalb eines Beobachtungsintervalls in zwei zum jeweiligen Bildpunkt gehörigen Kenngrößenbereichen eines Mess-Signals ermittelten Häufigkeit von jeweils gemessenen Kenngrößen-Paaren des Mess-Signals mit, für jeden Bildpunkt,
- einer ersten seriellen Anordnung (20), zur Erzeugung eines zeitlich verlängert aktiven, die Farbstufe selektierenden Farbauswahlsignals mit einer
o ersten Verzögerungs-Einheit (23, 26),
o einer ersten Abbildungs-Einheit (21), wobei die erste Abbildungs-Einheit (21) eine gestufte nichtlineare Kennlinie zur Umsetzung eines die ermittelte Häufigkeit repräsentierenden Eingangssignals (NofTreffer) in das Farbauswahlsignal mit der zur Häufigkeit korrespondierenden und zu selektierenden Farbstufe aufweist,
wobei die erste Verzögerungs-Einheit (23, 26)
▪ einen ersten Schalter (23) mit einem ersten Eingang (22), einem zweiten Eingang (25), und einem Ausgang (24), und
▪ ein erstes Verzögerungsglied (26), welches den Ausgang (24) des ersten Schalters (23) mit dem zweiten Eingang (25) des ersten Schalters (23) verbindet, und welches ausgebildet ist, um ein Signal am Ausgang (24) des ersten Schalters (23) um eine Abtastzeit zeitlich zu verzögern und dem zweiten Eingang (25) des ersten Schalters (23) zuzuführen, aufweist,
wobei ein Ausgangssignal der ersten Abbildungs-Einheit (21) an den ersten Eingang (22) des ersten Schalters (23) gelegt ist,
wobei der erste Schalter (23) ausgebildet ist,
• um das an seinem ersten Eingang (22) anliegende Ausgangssignal der ersten Abbildungs-Einheit (21) an den Ausgang (24) des ersten Schalters (23) durchzuschalten, solange das Eingangssignal (NofTreffer) einen ermittelte Häufigkeitswert von mindestens "1" repräsentiert, und
• um das Signal am zweiten Eingang 25 des ersten Schalters (23) an den Ausgang 24 des ersten Schalters (23) durchzuschalten, sobald der ermittelte Häufigkeitswert des Eingangssignals (NofTreffer) nach Ablauf eines Beobachtungsintervalls auf den Wert "0" zurückgesetzt wird,
- einer zweiten seriellen Anordnung (30), zur Erzeugung eines zeitlich verlängert aktiven, die Helligkeitsstufe selektierenden Helligkeitsauswahlsignals, mit
o einer zweiten Verzögerungs-Einheit (32, 35, 36), und
o einer zweiten Abbildungs-Einheit (37), wobei die zweite Abbildungs-Einheit (37) eine nichtlinear gestufte Kennlinie aufweist, und einen Helligkeitswert eines Helligkeitssignals mit einem Wertebereich zwischen 0 und 1 in das Helligkeitsauswahlsignal umsetzt, dessen Signalwert einer zum Helligkeitswert des Helligkeitssignals korrespondierenden Helligkeitsstufe entspricht,
wobei die zweite Verzögerungs-Einheit (32, 35, 36)
o einen zweiten Schalter (32) mit einem ersten Eingang (31), einem zweiten Eingang (34), und einem Ausgang (33),
o ein Multiplizierglied (36), verbunden mit dem zweiten Eingang (34) des zweiten Schalters (32), und
o ein zweites Verzögerungsglied (35), welches den Ausgang (33) des zweiten Schalters (32) mit dem Multiplizierglied (36) verbindet, und welches ausgebildet ist, um das Helligleitssignal am Ausgang (33) des zweiten Schalters (32) um eine Abtastzeit zeitlich zu verzögern und dem Multiplizierglied (36) zuzuführen, aufweist,
wobei das Multiplizierglied (36) ausgebildet ist, um das um eine Abtastzeit verzögerte Helligkeitssignal am Ausgang (33) des zweiten Schalters (32) mit einem Gedächtnisfaktor für ein Nachleuchten (G) zu multiplizieren und dem zweiten Eingang (34) des zweiten Schalters (32) zuzuführen,
wobei der Ausgang (33) des zweiten Schalters (32) mit der zweiten Abbildungs-Einheit (37) verbunden ist,
wobei der erste Eingang (31) des zweiten Schalters (32) mit einem Signal mit dem Wert 1 beaufschlagt ist,
wobei der zweite Schalter (32) ausgebildet ist,
- um das Signal mit dem Wert 1 am ersten Eingang (31) des zweiten Schalters (32) an den Ausgang (33) des zweiten Schalters (32) durchzuschalten, wenn das Eingangssignal (NofTreffer) eine von "0" verschiedenen Häufigkeitswert aufweist, und
- um ein Signal am zweiten Eingang (34) des zweiten Schalters (32) an den Ausgang (33) des zweiten Schalters (32) durchzuschalten, sobald der ermittelte Häufigkeitswert des Eingangssignals (NofTreffer) nach Ablauf eines Beobachtungsintervalls auf den Wert "0" zurückgesetzt wird, und
- einem Speicher (40), verbunden mit dem Ausgang (24) des ersten Schalters (23) und der zweiten Abbildungs-Einheit (37), mit vom Farbauswahlsignal und vom Helligkeitsauswahlsignal adressierbaren Speicherzellen, in denen eine Beleuchtungsinformation aus jeweils einer unterschiedlichen Kombination aus einer Farbstufe und einer Helligkeitsstufe gespeichert ist.

2. Vorrichtung zur Auswahl einer aus einer Farbstufe und einer Helligkeitsstufe zusammengesetzten Beleuchtungsinformation nach Anspruch 1,
**dadurch gekennzeichnet,**
**dass** die erste Verzögerungs-Einheit (23, 26) ein erstes nichtlineares rekursives digitales Filter erster Ordnung zur Fixierung der zu selektierenden Farbstufe des Farbauswahlsignals über mindestens ein Beobachtungsintervall darstellt.

3. Vorrichtung zur Auswahl einer aus einer Farbstufe und einer Helligkeitsstufe zusammengesetzten Beleuchtungsinformation nach Anspruch 1 oder 2,
**dadurch gekennzeichnet,**
**dass** die zweite Verzögerungs-Einheit (32, 35, 36) ein zweites nichtlineares rekursives digitales Filter erster Ordnung zur Reduzierung der zu selektierenden Helligkeitsstufe des Helligkeitsauswahlsignals über mindestens ein Beobachtungsintervall darstellt.

4. Vorrichtung zur Auswahl einer aus einer Farbstufe und einer Helligkeitsstufe zusammengesetzten Beleuchtungsinformation nach einem der Ansprüche 1 bis 3,
**dadurch gekennzeichnet,**
**dass** der Speicher (40) eine zweidimensionale Speicherorganisation aufweist, wobei in einer ersten Dimension der Speicherorganisation die Speicherzellen mit einer Beleuchtungsinformation aus jeweils einer identischen Farbstufe und unterschiedlichen Helligkeitsstufen und in einer zweiten Dimension der Speicherorganisation die Speicherzellen mit einer Beleuchtungsinformation aus jeweils einer identischen Helligkeitsstufe und unterschiedlichen Farbstufen angeordnet sind.

5. Vorrichtung zur Auswahl einer aus einer Farbstufe und einer Helligkeitsstufe zusammengesetzten Beleuchtungsinformation nach einem der Ansprüche 1 bis 4,
**dadurch gekennzeichnet,**
**dass** ein dritter Schalter (70) zum Durchschalten des von der ersten seriellen Anordnung (20) erzeugten Farbauswahlsignals und gleichzeitig des von der zweiten seriellen Anordnung (30) erzeugten Helligkeitsauswahlsignals oder eines von einer dritten Abbildungs-Einheit (50) erzeugten zusätzlichen Farbauswahlsignals und gleichzeitig eines von einer vierten Abbildungs-Einheit (60) erzeugten zusätzlichen Helligkeitsauswahlsignals an den Speicher (40) vorgesehen ist.

6. Vorrichtung zur Auswahl einer aus einer Farbstufe und einer Helligkeitsstufe zusammengesetzten Beleuchtungsinformation nach Anspruch 5,
**dadurch gekennzeichnet,**
**dass** die dritte Abbildungs-Einheit (50) eine gestufte nichtlineare Kennlinie zur Umsetzung eines einer ermittelten statischen Kenngröße entsprechenden Signalwerts eines Eingangsignals (statNofTreffer) in einen Signalwert eines zusätzlichen Farbauswahlsignals, der der zur ermittelten statistischen Kenngröße korrespondierenden Farbstufe entspricht, aufweist.

7. Vorrichtung zur Auswahl einer aus einer Farbstufe und einer Helligkeitsstufe zusammengesetzten Beleuchtungsinformation nach Anspruch 5 oder 6,
**dadurch gekennzeichnet,**
**dass** die vierte Abbildungs-Einheit (60) eine gestufte nichtlineare Kennlinie zur Umsetzung eines einer ermittelten statistischen Kenngröße entsprechenden Signalwerts eines Eingangsignals (statNofTreffer) in einen Signalwert eines zusätzlichen Helligkeitsauswahlsignals, der der zu einer frei wählbaren zusätzlichen Helligkeitswert korrespondierenden Helligkeitsstufe entspricht, aufweist.

## Claims

1. Apparatus for selecting illumination information, made up of a colour grade and a brightness level, for each picture element on a display of a display device on the basis of a frequency, ascertained within an observation interval in two parameter ranges of a measurement signal that are associated with the respective picture element, of respectively measured parameter pairs of the measurement signal, having, for each picture element,
- a first series arrangement (20), for producing a colour selection signal that is active for an extended period of time and selects the colour grade, having
o a first delay unit (23, 26),
o a first mapping unit (21), wherein the first mapping unit (21) has a graduated nonlinear characteristic curve for converting an input signal (NofTreffer) representing the ascertained frequency into the colour selection signal with the colour grade to be selected that corresponds to the frequency,
wherein the first delay unit (23, 26) has
• a first switch (23) having a first input (22), a second input (25) and an output (24), and
• a first delay element (26), which connects the output (24) of the first switch (23) to the second input (25) of the first switch (23), and which is designed to delay the timing of a signal at the output (24) of the first switch (23) by a sampling time and to supply said signal to the second input (25) of the first switch (23),
wherein an output signal of the first mapping unit (21) is applied to the first input (22) of the first switch (23),
wherein the first switch (23) is designed
• to connect the output signal of the first mapping unit (21), which is supplied to the first input (22) of said first switch, to the output (24) of the first switch (23) while the input signal (NofTreffer) represents an ascertained frequency value of at least "1", and
• to connect the signal at the second input (25) of the first switch (23) to the output (24) of the first switch (23) as soon as the ascertained frequency value of the input signal (NofTreffer) is reset to the value "0" after an observation interval has elapsed,
- a second series arrangement (30), for producing a brightness selection signal that is active for an extended period of time and selects the brightness level, having
o a second delay unit (32, 35, 36), and
o a second mapping unit (37), wherein the second mapping unit (37) has a nonlinearly graduated characteristic curve and converts a brightness value of a brightness signal having a value range between 0 and 1 into the brightness selection signal, the signal value of which is consistent with a brightness level that corresponds to the brightness value of the brightness signal,
wherein the second delay unit (32, 35, 36) has
o a second switch (32) having a first input (31), a second input (34) and an output (33), and
o a multiplication element (36), connected to the second input (34) of the second switch (32), and
o a second delay element (35), which connects the output (33) of the second switch (32) to the multiplication element (36), and which is designed to delay the timing of the brightness signal at the output (33) of the second switch (32) by a sampling time and to supply said brightness signal to the multiplication element (36),
wherein the multiplication element (36) is designed to multiply the brightness signal delayed by a sampling time at the output (33) of the second switch (32) by a recall factor for a persistence (G) and to supply said brightness signal to the second input (34) of the second switch (32),
wherein the output (33) of the second switch (32) is connected to the second mapping unit (37), wherein the first input (31) of the second switch (32) has a signal having the value 1 applied to it, wherein the second switch (32) is designed
- to connect the signal having the value 1 at the first input (31) of the second switch (32) to the output (33) of the second switch (32) if the input signal (NofTreffer) has a frequency value different from "0", and
- to connect a signal at the second input (34) of the second switch (32) to the output (33) of the second switch (32) as soon as the ascertained frequency value of the input signal (NofTreffer) is reset to the value "0" after an observation interval has elapsed, and
- a memory (40), connected to the output (24) of the first switch (23) and the second mapping unit (37), having memory cells that are addressable by the colour selection signal and by the brightness selection signal and in which illumination information comprising a respective different combination of a colour grade and a brightness level is stored.

2. Apparatus for selecting illumination information made up of a colour grade and a brightness level according to Claim 1,
**characterized**
**in that** the first delay unit (23, 26) is a first first-order nonlinear recursive digital filter for fixing the colour grade to be selected in the colour selection signal over at least one observation interval.

3. Apparatus for selecting illumination information made up of a colour grade and a brightness level according to Claim 1 or 2,
**characterized**
**in that** the second delay unit (32, 35, 36) is a second first-order nonlinear recursive digital filter for reducing the brightness level to be selected in the brightness selection signal over at least one observation interval.

4. Apparatus for selecting illumination information made up of a colour grade and a brightness level according to one of Claims 1 to 3,
**characterized**
**in that** the memory (40) has a two-dimensional memory organization, wherein the memory cells with illumination information comprising in each case an identical colour grade and different brightness levels are arranged in a first dimension of the memory organization and the memory cells with illumination information comprising in each case an identical brightness level and different colour grades are arranged in a second dimension of the memory organization.

5. Apparatus for selecting illumination information made up of a colour grade and a brightness level according to one of Claims 1 to 4,
**characterized**
**in that** there is provision for a third switch (70) for connecting the colour selection signal generated by the first series arrangement (20) and at the same time the brightness selection signal generated by the second series arrangement (30) or an additional colour selection signal generated by a third mapping unit (50) and at the same time an additional brightness selection signal generated by a fourth mapping unit (60) to the memory (40) .

6. Apparatus for selecting illumination information made up of a colour grade and a brightness level according to Claim 5,
**characterized**
**in that** the third mapping unit (50) has a graduated nonlinear characteristic curve for converting a signal value of an input signal (statNofTreffer), which signal value is consistent with an ascertained static parameter, into a signal value of an additional colour selection signal, which signal value is consistent with the colour grade that corresponds to the ascertained statistical parameter.

7. Apparatus for selecting illumination information made up of a colour grade and a brightness level according to Claim 5 or 6,
**characterized**
**in that** the fourth mapping unit (60) has a graduated nonlinear characteristic curve for converting a signal value of an input signal (statNofTreffer), which signal value is consistent with an ascertained statistical parameter, into a signal value of an additional brightness selection signal, which signal value is consistent with the brightness level that corresponds to a freely selectable additional brightness value.

## Revendications

1. Dispositif pour choisir une information d'éclairage composée d'un échelon de couleur et d'un échelon de brillance pour chaque point d'image sur un écran d'un dispositif d'affichage en fonction d'une fréquence, déterminée pendant un intervalle d'observation dans deux plages de grandeurs caractéristiques d'un signal de mesure faisant partie du point d'image respectif, de paires de grandeurs caractéristiques mesurées respectivement du signal de mesure avec, pour chaque point d'image,
- un premier ensemble sériel (20), pour la génération d'un signal de choix de couleur actif prolongé dans le temps, sélectionnant l'échelon de couleur, avec une
∘ première unité de retard (23, 26),
∘ une première unité d'imagerie (21), dans lequel la première unité d'imagerie (21) présente une courbe caractéristique non linéaire étagée pour la conversion d'un signal d'entrée (NofTreffer) représentant la fréquence déterminée en le signal de choix de couleur avec l'échelon de couleur correspondant à la fréquence et à sélectionner,
dans lequel la première unité de retard (23, 26) présente
▪ un premier commutateur (23) avec une première entrée (22), une deuxième entrée (25), et une sortie (24), et
▪ un premier élément de retard (26), lequel relie la sortie (24) du premier commutateur (23) à la deuxième entrée (25) du premier commutateur (23), et lequel est réalisé pour retarder dans le temps d'un temps de balayage un signal à la sortie (24) du premier commutateur (23) et l'amener à la deuxième entrée (25) du premier commutateur (23),
dans lequel un signal de sortie de la première unité d'imagerie (21) est placé à la première entrée (22) du premier commutateur (23),
dans lequel le premier commutateur (23) est réalisé
• pour commuter le signal de sortie, s'appliquant à sa première entrée (22), de la première unité d'imagerie (21) à la sortie (24) du premier commutateur (23), tant que le signal d'entrée (NofTreffer) représente une valeur de fréquence déterminée d'au moins « 1 », et
• pour commuter le signal à la deuxième entrée 25 du premier commutateur (23) à la sortie 24 du premier commutateur (23), dès que la valeur de fréquence déterminée du signal d'entrée (NofTreffer) est remise sur la valeur « 0 » après expiration d'un intervalle d'observation,
- un deuxième ensemble sériel (30), pour la génération d'un signal de choix de brillance prolongé dans le temps, sélectionnant l'échelon de brillance, avec
∘ une deuxième unité de retard (32, 35, 36), et
∘ une deuxième unité d'imagerie (37), dans lequel la deuxième unité d'imagerie (37) présente une courbe caractéristique étagée non linéaire, et convertit une valeur de brillance d'un signal de brillance avec une plage de valeurs entre 0 et 1 en le signal de choix de brillance dont la valeur de signal correspond à un échelon de brillance correspondant à la valeur de brillance du signal de brillance,
dans lequel la deuxième unité de retard (32, 35, 36) présente
∘ un deuxième commutateur (32) avec une première entrée (31), une deuxième entrée (34), et une sortie (33),
∘ un élément de multiplication (36), relié à la deuxième entrée (34) du deuxième commutateur (32), et
∘ un deuxième élément de retard (35), lequel relie la sortie (33) du deuxième commutateur (32) à l'élément de multiplication (36), et lequel est réalisé pour retarder dans le temps d'un temps de balayage le signal de brillance à la sortie (33) du deuxième commutateur (32) et l'amener à l'élément de multiplication (36),
dans lequel l'élément de multiplication (36) est réalisé pour multiplier le signal de brillance retardé d'un temps de balayage à la sortie (33) du deuxième commutateur (32) par un facteur de mémoire pour une luminescence persistante (G) et l'amener à la deuxième entrée (34) du deuxième commutateur (32),
dans lequel la sortie (33) du deuxième commutateur (32) est reliée à la deuxième unité d'imagerie (37),
dans lequel un signal avec la valeur 1 est appliqué à la première entrée (31) du deuxième commutateur (32),
dans lequel le deuxième commutateur (32) est réalisé
- pour commuter le signal avec la valeur 1 à la première entrée (31) du deuxième commutateur (32) à la sortie (33) du deuxième commutateur (32), lorsque le signal d'entrée (NofTreffer) présente une valeur de fréquence différente de « 0 », et
- pour commuter un signal à la deuxième entrée (34) du deuxième commutateur (32) à la sortie (33) du deuxième commutateur (32), dès que la valeur de fréquence déterminée du signal d'entrée (NofTreffer) est remise sur la valeur « 0 » après expiration d'un intervalle d'observation, et
- une mémoire (40), reliée à la sortie (24) du premier commutateur (23) et de la deuxième unité d'imagerie (37), avec des cellules de mémoire pouvant être adressées par le signal de choix de couleur et le signal de choix de brillance, dans lesquelles une information d'éclairage composée respectivement d'une combinaison différente d'un échelon de couleur et d'un échelon de brillance est mise en mémoire.

2. Dispositif pour choisir une information d'éclairage composée d'un échelon de couleur et d'un échelon de brillance selon la revendication 1,
**caractérisé en ce**
**que** la première unité de retard (23, 26) représente un premier filtre numérique récursif non linéaire de premier ordre pour la fixation de l'échelon de couleur, à sélectionner, du signal de choix de couleur pendant au moins un intervalle d'observation.

3. Dispositif pour choisir une information d'éclairage composée d'un échelon de couleur et d'un échelon de brillance selon la revendication 1 ou 2,
**caractérisé en ce**
**que** la deuxième unité de retard (32, 35, 36) représente un deuxième filtre numérique récursif non linéaire de premier ordre pour la réduction de l'échelon de couleur, à sélectionner, du signal de choix de brillance pendant au moins un intervalle d'observation.

4. Dispositif pour choisir une information d'éclairage composée d'un échelon de couleur et d'un échelon de brillance selon l'une quelconque des revendications 1 à 3,
**caractérisé en ce**
**que** la mémoire (40) présente une organisation de mémoire bidimensionnelle, dans lequel les cellules de mémoire avec une information d'éclairage composée respectivement d'un échelon de couleur identique et de différents échelons de brillance sont disposées dans une première dimension de l'organisation de mémoire, et les cellules de mémoire avec une information d'éclairage composée respectivement d'un échelon de brillance identique et de différents échelons de couleur dans une deuxième dimension de l'organisation de mémoire.

5. Dispositif pour choisir une information d'éclairage composée d'un échelon de couleur et d'un échelon de brillance selon l'une quelconque des revendications 1 à 4,
**caractérisé en ce**
**qu'**un troisième commutateur (70) destiné à commuter le signal de choix de couleur généré par le premier agencement sériel (20) et simultanément le signal de choix de brillance généré par le deuxième agencement sériel (30) ou un signal de choix de couleur additionnel généré par une troisième unité d'imagerie (50) et simultanément un quatrième signal de choix de brillance additionnel généré par une quatrième unité d'imagerie (60) est prévu sur la mémoire (40).

6. Dispositif pour choisir une information d'éclairage composée d'un échelon de couleur et d'un échelon de brillance selon la revendication 5,
**caractérisé en ce**
**que** la troisième unité d'imagerie (50) présente une courbe caractéristique non linéaire étagée pour la conversion d'une valeur de signal, correspondant à une grandeur caractéristique statique déterminée, d'un signal d'entrée (statNofTreffer) en une valeur de signal d'un signal de choix de couleur additionnel, qui correspond à l'échelon de couleur correspondant à la grandeur caractéristique statique déterminée.

7. Dispositif pour choisir une information d'éclairage composée d'un échelon de couleur et d'un échelon de brillance selon la revendication 5 ou 6,
**caractérisé en ce**
**que** la quatrième unité d'imagerie (60) présente une courbe caractéristique non linéaire étagée pour la conversion d'une valeur de signal, correspondant à une grandeur caractéristique statistique déterminée, d'un signal d'entrée (statNofTreffer) en une valeur de signal d'un signal de choix de brillance additionnel, qui correspond à l'échelon de brillance correspondant à une valeur de brillance additionnelle pouvant être choisie librement.
